# EUROPÄISCHE PATENTSCHRIFT

(11) **EP 2 891 193 B1**
(45) Veröffentlichungstag und Bekanntmachung des Hinweises auf die Patenterteilung: **24.02.2021**
(21) Anmeldenummer: 13739707.1
(22) Anmeldetag: 22.07.2013
(51) Int. Cl.: H01L 33/64

(54) **LEUCHTDIODENVORRICHTUNG**
LIGHT-EMITTING DIODE DEVICE
DISPOSITIF DE DIODE ÉLECTROLUMINESCENTE

(30) Priorität: 31.08.2012 DE 102012108107
(43) Veröffentlichungstag der Anmeldung: 08.07.2015
(73) Patentinhaber: TDK Electronics AG, 81671 München (DE)
(72) Erfinder: FEICHTINGER, Thomas, A-8010 Graz (AT); BRUNNER, Sebastian, A-8042 Graz (AT); DERNOVSEK, Oliver, A-8501 Lieboch (AT); AICHHOLZER, Klaus-Dieter, A-8530 Deutschlandsberg (AT); KRENN, Georg, A-8020 Graz (AT); PECINA, Axel, A-8543 St. Martin (AT); FAISTAUER, Christian, A-8523 Frauental (AT)
(74) Vertreter: Epping - Hermann - Fischer
(86) Internationale Anmeldenummer: PCT/EP2013/065439
(87) Internationale Veröffentlichungsnummer: WO 2014/032859

(56) Entgegenhaltungen:
- US-A1- 2007 126 093
- US-A1- 2007 200 133
- US-A1- 2008 043 444
- US-A1- 2008 290 353
- US-A1- 2009 250 709
- US-A1- 2010 264 442
- US-A1- 2012 007 076
- US-A1- 2012 181 696

## Beschreibung

Es wird eine Leuchtdiodenvorrichtung angegeben, die zumindest einen Träger und einen auf dem Träger angeordneten Leuchtdiodenchip aufweist.

Beim Design von Systemen mit lichtemittierenden Dioden (LEDs) spielen Lichtausbeute, Lebensdauer und thermisches Management eine immer wichtigere Rolle. Neben funktionalen Herauforderungen gibt es auch thermomechanische und geometrische Probleme zu lösen. Speziell bei mobilen Anwendungen, beispielsweise für einen integrierten LED-Kamerablitz in Smartphones oder Digitalkameras, sollen die LED sowie diskrete Schutzbauelemente eine möglichst geringe Bauhöhe aufweisen und möglichst wenig Platz einnehmen. Eine weitere wichtige Anforderung an die Gehäuselösung liegt darin, dass die LED für die Lichtabstrahlung so weit wie möglich frei von anderen Bauelementen ist und dass es keine Abschattungen durch die Schutzbauelemente gibt.

Die Druckschrift US 2008/043444 A1 offenbart eine Leuchtdiodenvorrichtung, die einen ersten Träger und zumindest einen Leuchtdiodenchip, der auf dem ersten Träger angeordnet ist, aufweist. Der erste Träger weist zumindest einen ersten und einen zweiten Trägerteil auf, wobei der Leuchtdiodenchip nur auf dem ersten Trägerteil aufliegt.

Es ist eine Aufgabe zumindest einiger Ausführungsformen, eine Leuchtdiodenvorrichtung anzugeben.

Diese Aufgabe wird durch die Gegenstände der unabhängigen Patentansprüche gelöst. Vorteilhafte Ausführungsformen und Weiterbildungen der Gegenstände gehen weiterhin aus den abhängigen Patentansprüchen, der nachfolgenden Beschreibung und aus den Zeichnungen hervor.

Eine Leuchtdiodenvorrichtung gemäß zumindest einer Ausführungsform weist einen ersten Träger auf. Der erste Träger kann beispielsweise ein keramisches Material, wie zum Beispiel Aluminiumoxid oder Aluminiumnitrid, ein organisches Material, wie zum Beispiel ein Polymer oder Epoxidharz, und/oder ein metallisches Material, wie zum Beispiel Aluminium oder Kupfer, aufweisen.

Die Leuchtdiodenvorrichtung weist weiterhin zumindest einen Leuchtdiodenchip auf, der auf dem ersten Träger angeordnet ist. Beispielsweise kann der Leuchtdiodenchip mindestens eines der folgenden Materialien aufweisen: Galliumphosphid (GaP), Galliumnitrid (GaN), Galliumarsenphosphid (GaAsP), Aluminiumgalliumindiumphosphid (AlGaInP), Aluminiumgalliumphosphid (AlGaP), Aluminiumgalliumarsenid (AlGaAs), Indiumgalliumnitrid (InGaN), Aluminiumnitrid (AlN), Aluminiumgalliumnitrid (AlGaN), Aluminiumgalliumindiumnitrid (AlGaInN), Zinkselenid (ZnSe).

Gemäß einer weiteren Ausführungsform weist der Leuchtdiodenchip mindestens zwei Kontaktflächen auf. Vorzugsweise sind die Kontaktflächen lötbar. Beispielsweise weisen die Kontaktflächen eine Legierung oder eine Schichtfolge mit einer der folgenden Materialkombinationen auf oder bestehen daraus: Cu/Ni/Au, Cr/Ni/Au, Cr/Cu/Ni/Au, Cu/Ni/Sn, Cr/Ni/Sn, Cr/Cu/Ni/Sn.

Gemäß einer weiteren Ausführungsform weist der erste Träger zumindest einen ersten und einen zweiten Trägerteil auf. Vorzugsweise grenzen der erste Trägerteil und der zweite Trägerteil aneinander an. Der erste Trägerteil des ersten Trägers ist vom zweiten Trägerteil des ersten Trägers lateral umschlossen. Das kann insbesondere bedeuten, dass der erste Trägerteil seitlich vollständig vom zweiten Trägerteil umgeben ist, wobei seitlich eine Richtung senkrecht zur Anordnungsrichtung des Leuchtdiodenchips auf dem ersten Träger bezeichnen kann. Das erste Trägerteil kann dabei insbesondere auch durch das zweite Trägerteil hindurchragen und somit an einer dem Leuchtdiodenchip zugewandten Seite und einer dem Leuchtdiodenchip weg gewandten Seite eine Oberfläche oder Teil einer Oberfläche des ersten Trägers bilden. Der erste und der zweite Trägerteil können beispielsweise einen Trägerkörper des ersten Trägers bilden. Der erste Träger kann weiterhin Anschlusselemente zur elektrischen Kontaktierung des Leuchtdiodenchips, wie zum Beispiel Leiterbahnen, Anschlussflächen oder weitere elektrische Kontaktelemente, aufweisen. Der erste und der zweite Trägerteil weisen jeweils eine thermische Leitfähigkeit auf, wobei sich die thermischen Leitfähigkeiten des ersten und des zweiten Trägerteils voneinander unterscheiden.

Besonders bevorzugt liegt der Leuchtdiodenchip nur auf dem ersten Trägerteil des ersten Trägers auf. Das kann insbesondere bedeuten, dass der Leuchtdiodenchip in einer Aufsicht auf den ersten Träger vom Leuchtdiodenchip aus gesehen nur auf dem ersten Trägerteil angeordnet ist. Mit "aufliegen" kann hier und im Folgenden eine unmittelbare oder mittelbare Anordnung des Leuchtdiodenchips auf dem ersten Trägerteil bezeichnet sein. Zwischen dem ersten Trägerteil und dem darauf aufliegenden Leuchtdiodenchip können somit auch ein oder mehrere Anschlusselemente und/oder eine oder mehrere Verbindungsschichten zur Montage des Leuchtdiodenchips auf dem ersten Trägerteil angeordnet sein.

Gemäß der Erfindung weist der erste Trägerteil des ersten Trägers eine höhere thermische Leitfähigkeit auf als der zweite Trägerteil des ersten Trägers.

Gemäß einer bevorzugten Ausführungsform beträgt die thermische Leitfähigkeit des ersten Trägerteils mindestens das 1,5-Fache der thermischen Leitfähigkeit des zweiten Trägerteils. Mittels des ersten Trägerteils, auf dem der Leuchtdiodenchip angeordnet ist und der eine im Vergleich zum zweiten Trägerteil hohe thermische Leitfähigkeit aufweist, kann besonders gut Wärme vom Leuchtdiodenchip abgeführt werden, beispielsweise in Richtung eines Gehäuses der Leuchtdiodenvorrichtung, zu dem der erste Trägerteil vorzugsweise einen guten thermischen Kontakt aufweist.

Gemäß der Erfindung weist die Leuchtdiodenvorrichtung einen ersten Träger sowie zumindest einen Leuchtdiodenchip auf, der auf dem ersten Träger angeordnet ist. Der erste Träger weist zumindest einen ersten und einen zweiten Trägerteil auf, wobei der Leuchtdiodenchip nur auf dem ersten Trägerteil des ersten Trägers aufliegt, und der erste Trägerteil des ersten Trägers ist vom zweiten Trägerteil des ersten Trägers lateral umschlossen. Der erste und der zweite Trägerteil weisen jeweils eine thermische Leitfähigkeit auf, wobei die thermische Leitfähigkeit des ersten Trägerteils mindestens das 1,5-Fache der thermischen Leitfähigkeit des zweiten Trägerteils beträgt.

Gemäß einer weiteren besonders bevorzugten Ausführungsform beträgt die thermische Leitfähigkeit des ersten Trägerteils mindestens das 5-Fache der thermischen Leitfähigkeit des zweiten Trägerteils. Dadurch kann besonders viel Wärme vom Leuchtdiodenchip weggeleitet werden. Beispielsweise kann der zweite Trägerteil Aluminiumoxid enthalten und eine thermische Leitfähigkeit von in etwa 25 W/mK aufweisen und der erste Trägerteil Silber mit einem Glas- oder Keramikfüller enthalten und eine thermische Leitfähigkeit von in etwa 150 W/mK aufweisen.

Gemäß einer weiteren Ausführungsform weist die Leuchtdiodenvorrichtung einen zweiten Träger auf, auf dem der erste Träger angeordnet ist. Der zweite Träger weist zumindest einen ersten und einen zweiten Trägerteil auf. Der erste Trägerteil des zweiten Trägers und der zweite Trägerteil des zweiten Trägers weisen jeweils eine thermische Leitfähigkeit auf, wobei sich die thermischen Leitfähigkeiten des ersten und zweiten Trägerteils des zweiten Trägers vorzugsweise voneinander unterscheiden. Vorzugsweise weist der erste Trägerteil des zweiten Trägers eine höhere thermische Leitfähigkeit auf als der zweite Trägerteil des zweiten Trägers. Der erste Trägerteil des zweiten Trägers ist vom zweiten Trägerteil des zweiten Trägers lateral umschlossen.

Gemäß einer weiteren Ausführungsform sind die ersten Trägerteile des ersten und zweiten Trägers übereinander angeordnet. Das kann insbesondere bedeuten, dass der erste Träger so auf dem zweiten Träger angeordnet ist, dass der erste Trägerteil des ersten Trägers auf dem ersten Trägerteil des zweiten Trägers angeordnet ist. Durch eine derartige Anordnung kann eine besonders gute Wärmeableitung weg vom Leuchtdiodenchip erreicht werden.

Gemäß einer weiteren bevorzugten Ausführungsform weist die Leuchtdiodenvorrichtung einen ersten Träger auf, auf dem zumindest ein Leuchtdiodenchip angeordnet ist, und einen zweiten Träger, auf dem der erste Träger angeordnet ist. Der erste und der zweite Träger weisen jeweils einen ersten und einen zweiten Trägerteil auf, wobei der Leuchtdiodenchip vorzugsweise nur auf dem ersten Trägerteil des ersten Trägers aufliegt. Die ersten und die zweiten Trägerteile weisen jeweils eine thermische Leitfähigkeit auf. Vorzugsweise weist der erste Trägerteil des ersten Trägers eine höhere thermische Leitfähigkeit als der zweite Trägerteil des ersten Trägers und der erste Trägerteil des zweiten Trägers weist eine höhere thermische Leitfähigkeit als der zweite Trägerteil des zweiten Trägers auf. Weiterhin sind die ersten Trägerteile vorzugsweise übereinander angeordnet, wobei der erste Trägerteil des ersten Trägers vom zweiten Trägerteil des ersten Trägers und der erste Trägerteil des zweiten Trägers vom zweiten Trägerteil des zweiten Trägers lateral umschlossen sind.

Gemäß einer weiteren Ausführungsform beträgt die thermische Leitfähigkeit des ersten Trägerteils des zweiten Trägers mindestens das 1,5-Fache der thermischen Leitfähigkeit des zweiten Trägerteils des zweiten Trägers. Gemäß einer weiteren bevorzugten Ausführungsform beträgt die thermische Leitfähigkeit des ersten Trägerteils des zweiten Trägers mindestens das 5-Fache der thermischen Leitfähigkeit des zweiten Trägerteils des zweiten Trägers.

Gemäß einer weiteren Ausführungsform weist der zweite Trägerteil des ersten und/oder des zweiten Trägers ein keramisches Material, wie zum Beispiel Aluminiumoxid oder Aluminiumnitrid, ein organisches Material, wie zum Beispiel ein Polymer oder Epoxidharz, oder ein metallisches Material, wie zum Beispiel Aluminium oder Kupfer, auf. Weiterhin ist es möglich, dass der zweite Trägerteil des ersten und/oder des zweiten Trägers aus einem der vorgenannten Materialien besteht. Dabei können der zweite Trägerteil des ersten Trägers und der zweite Trägerteil des zweiten Trägers gleiche oder verschiedene Materialien aufweisen beziehungsweise aus gleichen oder verschiedenen Materialien bestehen.

Gemäß einer weiteren Ausführungsform weist der erste und/oder der zweite Träger ein metallisches Material auf, wobei das metallische Material mit einer elektrisch isolierenden Schicht versehen ist. Mittels der elektrisch isolierenden Schicht kann beispielsweise eine elektrische Isolierung zwischen dem ersten und dem zweiten Träger oder zwischen einem der Träger und einem darauf angeordneten Bauelement erreicht werden. Vorzugsweise weist die elektrisch isolierende Schicht eines der folgenden Materialien auf oder besteht aus einem der folgenden Materialien: Titanoxid, Aluminiumoxid, Aluminiumnitrid, Siliziumoxid, Siliziumnitrid.

Gemäß einer weiteren Ausführungsform weist der erste Träger eine erste Oberfläche auf, auf der der Leuchtdiodenchip angeordnet ist, sowie eine zweite Oberfläche, die der ersten Oberfläche gegenüberliegt. Vorzugsweise erstreckt sich der erste Trägerteil des ersten Trägers von der ersten zur zweiten Oberfläche. Dadurch kann eine besonders effiziente Wärmeableitung weg vom Leuchtdiodenchip erzielt werden.

Gemäß einer weiteren Ausführungsform weist der zweite Träger eine Oberfläche auf, auf der der erste Träger angeordnet ist, sowie eine zweite, der ersten Oberfläche des zweiten Trägers gegenüberliegende Oberfläche. Vorzugsweise erstreckt sich der erste Trägerteil des zweiten Trägers von der ersten zur zweiten Oberfläche des zweiten Trägers.

Gemäß einer weiteren Ausführungsform weist der erste Trägerteil des ersten Trägers thermische Vias, das heißt thermisch leitende Durchkontaktierungen, auf, die sich von einer ersten Oberfläche des ersten Trägers, auf der der Leuchtdiodenchip angeordnet ist, zu der der ersten Oberfläche gegenüberliegenden zweiten Oberfläche des ersten Trägers erstrecken. Via steht dabei für "vertical interconnect access". Die thermischen Vias können beispielsweise metallische Vias, das heißt mit einem Metall gefüllte Vias, sein. Zum Beispiel weisen die thermischen Vias Kupfer, Silber oder Silber-Palladium auf oder bestehen daraus.

Gemäß einer weiteren Ausführungsform weist der erste Trägerteil des zweiten Trägers thermische Vias auf. Die thermischen Vias können dabei wie vorab im Zusammenhang mit den thermischen Vias des ersten Trägers beschrieben ausgeführt sein.

Gemäß einer weiteren Ausführungsform weist der erste Trägerteil des ersten Trägers einen Metallbock auf oder besteht daraus. Der Metallblock weist vorzugsweise ein Metall mit einer hohen thermischen Leitfähigkeit, wie zum Beispiel Silber, auf oder besteht daraus.

Gemäß einer weiteren Ausführungsform weist der erste Trägerteil des zweiten Trägers einen Metallblock auf oder besteht aus einem Metallblock, wobei der Metallblock ein Metall mit einer hohen thermischen Leitfähigkeit, wie zum Beispiel Silber, aufweist oder daraus besteht.

Gemäß der Erfindung weist der erste Trägerteil des ersten Trägers Dotierungen auf. Die Dotierungen können beispielsweise als Metallpartikel, die zum Beispiel in einem Keramikmaterial eingebettet sein können, oder als metallische Dotierung, beispielsweise in einem Halbleitermaterial wie zum Beispiel Silizium oder Galliumarsenid, ausgeführt sein.

Gemäß einer weiteren Ausführungsform weist der erste Trägerteil des zweiten Trägers Dotierungen auf. Die Dotierungen im ersten Trägerteil des zweiten Trägers können beispielsweise wie die vorab im Zusammenhang mit den Dotierungen des ersten Trägerteils des ersten Trägers beschriebenen Dotierungen ausgeführt sein.

Mittels der thermischen Vias, des Metallblocks sowie der Dotierungen kann jeweils vorteilhafterweise die thermische Leitfähigkeit des ersten Trägerteils des ersten und/oder des zweiten Trägers signifikant erhöht werden.

Gemäß einer weiteren Ausführungsform weist der erste Träger ein ESD-Schutzelement auf. Dabei steht "ESD" hier und im Folgenden für "electrostatic discharge". Das ESD-Schutzelement dient vorzugsweise zum Schutz des Leuchtdiodenchips vor Überspannungen, insbesondere vor elektrostatischen Entladungen. Im Allgemeinen sind Leuchtdiodenchips sehr sensitiv gegenüber elektrostatischen Entladungen, insbesondere bei solchen mit einem Spannungswert von größer als 100 Volt, und müssen daher durch Schutzbauelemente geschützt werden. Das ESD-Schutzelement kann beispielsweise auf dem ersten Träger angeordnet sein.

Gemäß einer weiteren Ausführungsform ist das ESD-Schutzbauelement als Varistor ausgeführt. Der Varistor kann zum Beispiel in Form eines Mehrschichtvaristors, auch als Multi-Layer-Varistor (MLV) bezeichnet, ausgeführt sein. Vorzugsweise weist der Mehrschichtvaristor eine Varistorkeramik auf, die beispielsweise ein System aus ZnO-Pr, aus ZnO-Bi-Sb, aus SrTiO₃ oder aus SiC umfassen kann oder daraus bestehen kann. Weiterhin ist es möglich, dass das ESD-Schutzbauelement in Form einer Suppressordiode, insbesondere einer Siliziumhalbleiterschutzdiode, oder in Form eines Polymer-ESD-Schutzelement, also eines ESD-Schutzelements auf Polymerbasis, bei dem beispielsweise ein halbleitendes Material in ein Polymer eingebettet ist, ausgeführt ist.

Gemäß einer weiteren Ausführungsform weist der zweite Träger ein ESD-Schutzelement auf. Das ESD-Schutzelement kann beispielsweise auf dem zweiten Träger angeordnet sein. Das ESD-Schutzelement kann dabei insbesondere wie ein im Zusammenhang mit dem ersten Träger beschriebenes ESD-Schutzelement ausgeführt sein.

Gemäß einer weiteren Ausführungsform wird das ESD-Schutzelement durch einen Teilbereich des ersten und/oder des zweiten Trägers gebildet. Besonders bevorzugt kann das ESD-Schutzelement eine in den ersten und/oder den zweiten Träger integrierte Schutzstruktur sein. Mit anderen Worten ist das ESD-Schutzelement in diesem Fall nicht als diskretes Bauelement, beispielsweise in Form einer diskreten ESD-Schutzdiode, auf den Trägern montiert. Dabei kann es sein, dass das ESD-Schutzelement ein Material, zum Beispiel ein keramisches Varistormaterial, aufweist, das auch der erste und/oder zweite Träger aufweist. Alternativ ist es möglich, dass das ESD-Schutzelement ein Material aufweist, das vom Material oder den Materialien des ersten und/oder zweiten Trägers verschieden ist. Beispielsweise kann das ESD-Schutzelement ein halbleitendes Material, zum Beispiel ein keramisches Varistormaterial, aufweisen, das in den ersten und/oder zweiten Träger, der beispielsweise Aluminiumoxid, Aluminiumnitrid oder ein organisches Material aufweist, eingebettet ist.

Beispielsweise kann das durch einen Teilbereich des ersten oder zweiten Trägers gebildete ESD-Schutzelement eine Varistorkeramik und eine Mehrzahl von sich überlappenden Innenelektroden aufweisen. Alternativ ist es auch denkbar, dass das ESD-Schutzelement durch eine in den Träger integrierte Halbleiterdiode gebildet ist.

Dadurch, dass das ESD-Schutzelement durch einen Teilbereich des ersten und/oder des zweiten Trägers der Leuchtdiodenvorrichtung gebildet wird, kann vorteilhafterweise eine besonders kompakte Bauweise einer hier beschriebenen Leuchtdiodenvorrichtung erzielt werden.

Gemäß einer weiteren Ausführungsform weist die Leuchtdiodenvorrichtung ein Thermistorbauelement auf, das auf dem ersten oder zweiten Träger angeordnet sein kann. Beispielsweise kann das Thermistorbauelement als ultradünnes Schutzbauelement ausgebildet sein. Das kann insbesondere bedeuten, dass das elektrische Bauelement eine Bauhöhe von kleiner oder gleich 150 µm aufweisen kann. Weiterhin kann das Thermistorbauelement in den ersten und/oder zweiten Träger, beispielsweise in den zweiten Trägerteil des ersten und/oder zweiten Trägers, eingebettet sein.

Gemäß einer weiteren Ausführungsform ist das Thermistorbauelement als NTC-Thermistorbauelement ausgebildet, wobei "NTC" für "negative temperature coefficient" steht. Ein NTC-Thermistorbauelement zeichnet sich dadurch aus, dass Strom bei hohen Temperaturen besser geleitet wird als bei niedrigen Temperaturen. Daher kann das NTC-Thermistorbauelement auch als Heißleiter bezeichnet werden.

Vorzugsweise funktioniert das NTC-Thermistorbauelement als thermischer Sensor. Der thermische Sensor ist vorzugsweise mit dem Leuchtdiodenchip verschaltet. Beispielsweise kann der thermische Sensor zur Regulierung eines Steuerstroms des Leuchtdiodenchips beitragen, so dass dieser schonend betrieben werden kann. Dadurch kann vorteilhafterweise die Lebensdauer des Leuchtdiodenchips erhöht werden.

Gemäß einer weiteren Ausführungsform ist das Thermistorbauelement als PTC-Thermistorbauelement ausgebildet, wobei "PTC" für "positive temperature coefficient" steht. Das PTC-Thermistorbauelement ist vorzugsweise mit dem Leuchtdiodenchip verschaltet. Bei einem PTC-Thermistorbauelement wird Strom bei niedrigen Temperaturen besser geleitet als bei hohen Temperaturen, weshalb PTC-Thermistorbauelemente auch als Kaltleiter bezeichnet werden. Vorzugsweise funktioniert das PTC-Thermistorbauelement als Überstromschutzelement und schützt den Leuchtdiodenchip vor zu hohen Betriebsströmen, wodurch die Lebensdauer des Leuchtdiodenchips gesteigert werden kann.

Gemäß einer weiteren Ausführungsform weist die Leuchtdiodenvorrichtung einen dritten Träger auf. Vorzugsweise ist der zweite Träger mit einer dem ersten Träger abgewandten Seite auf dem dritten Träger angeordnet. Der dritte Träger kann ebenfalls einen ersten Trägerteil und einen den ersten Trägerteil lateral umschließenden zweiten Trägerteil aufweisen, wobei der erste Trägerteil vorzugsweise eine höhere thermische Leitfähigkeit als der zweite Trägerteil aufweist. Der dritte Träger kann weitere Merkmale aufweisen, die im Zusammenhang mit dem zweiten Träger beschrieben sind.

Gemäß einer weiteren Ausführungsform ist der Leuchtdiodenchip zumindest teilweise von einer Schutzbeschichtung umschlossen. Die Schutzbeschichtung kann beispielsweise als Linse der Leuchtdiodenvorrichtung dienen. Vorzugsweise weist die Schutzbeschichtung Silikon auf oder besteht aus Silikon.

Die hier beschriebene Leuchtdiodenvorrichtung kann vorteilhafterweise bei hoher Temperatur und Leistung mit hoher Lichtausbeute betrieben werden, ohne die Lebensdauer des Leuchtdiodenchips negativ zu beeinflussen.

Weitere Vorteile und vorteilhafte Ausführungsformen der Leuchtdiodenvorrichtung ergeben sich aus den im Folgenden in Verbindung mit den Figuren 1 bis 9 beschriebenen Ausführungsformen.

Es zeigen:
- Figuren 1 bis 3: schematische Schnittansichten von Leuchtdiodenvorrichtungen gemäß einigen Ausführungsbeispielen, die jeweils einen ersten Träger und zumindest einen Leuchtdiodenchip aufweisen,
- Figuren 4 bis 6: schematische Schnittansichten von Leuchtdiodenvorrichtungen gemäß weiteren Ausführungsbeispielen, die jeweils zumindest einen ersten und einen zweiten Träger sowie einen Leuchtdiodenchip aufweisen, und
- Figuren 7 bis 9: schematische Darstellungen eines ersten Trägerteils gemäß weiteren Ausführungsbeispielen.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen. Vielmehr können einzelne Elemente, wie zum Beispiel Schichten, Bauteile und Bereiche zur besseren Darstellbarkeit und/oder zum besseren Verständnis übertrieben dick oder groß dimensioniert dargestellt sein.

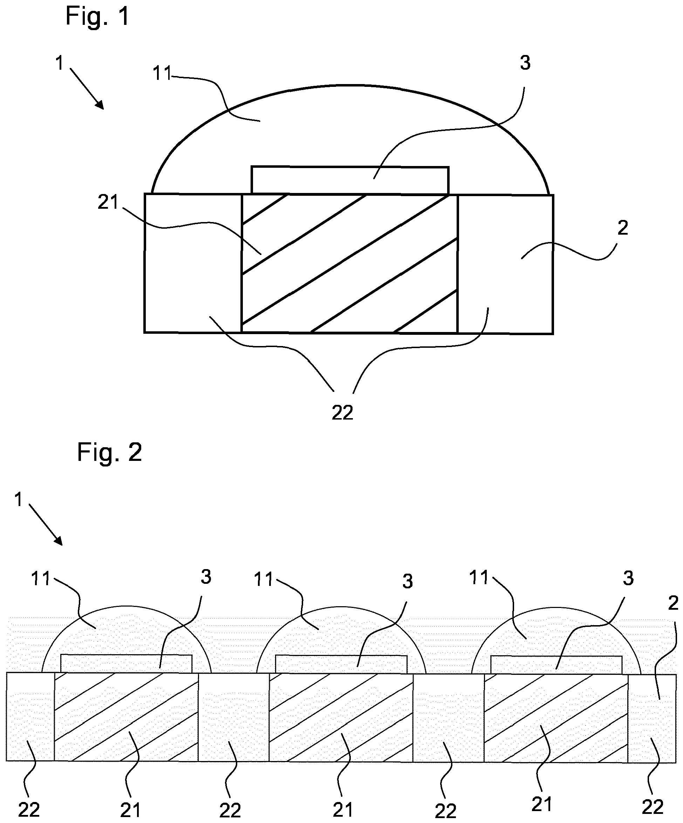

Figur 1 zeigt eine schematische Schnittansicht einer Leuchtdiodenvorrichtung 1 gemäß einem ersten Ausführungsbeispiel. Die Leuchtdiodenvorrichtung 1 umfasst einen ersten Träger 2, der einen ersten Trägerteil 21 sowie einen zweiten Trägerteil 22 aufweist. Der erste Trägerteil 21 erstreckt sich dabei von einer ersten Oberfläche des ersten Trägers 2 zu einer der ersten Oberfläche gegenüberliegenden zweiten Oberfläche des ersten Trägers 2 und ist lateral vom zweiten Trägerteil 22 umschlossen. Der erste und der zweite Trägerteil 21, 22 weisen ein elektrisch isolierendes Material, insbesondere ein keramisches Material, auf.

Weiterhin weist die Leuchtdiodenvorrichtung 1 einen Leuchtdiodenchip 3 auf, der auf dem ersten Träger 2 angeordnet ist und insbesondere nur auf dem ersten Trägerteil 21 aufliegt. Der Leuchtdiodenchip 3 weist Kontaktflächen (nicht gezeigt) auf, die der Kontaktierung und/oder der Montage des Leuchtdiodenchips 3 dienen. Beispielsweise ist der Leuchtdiodenchip 3 mit den Kontaktflächen auf dem ersten Träger 2 aufgelötet. Insbesondere bilden der erste und der zweite Trägerteil 21, 22 einen Trägerkörper des Trägers 2, wobei der Träger 2 neben den Trägerteilen 21, 22 weiterhin Anschlusselemente zur elektrischen Kontaktierung des Leuchtdiodenchips 3, wie zum Beispiel Leiterbahnen oder Anschlussflächen, die in elektrischem Kontakt mit den Kontaktflächen des Leuchtdiodenchips stehen, aufweisen kann (nicht gezeigt). Zwischen dem Leichtdiodenchip 3 und dem ersten Trägerteil 21 können beispielsweise auch eine oder mehrere Verbindungsschichten angeordnet sein.

Die Kontaktflächen des Leuchtdiodenchips 3 weisen eine Gold-Zinn-Legierung auf. Alternativ können die Kontaktflächen beispielsweise Kupfer, Nickel oder Gold oder eine Legierung oder Schichtenfolge aus zumindest zwei dieser Materialien aufweisen.

Weiterhin ist der Leuchtdiodenchip 3 von einer Schutzbeschichtung 11 umschlossen. Die Schutzbeschichtung 11 weist Silikon auf und wirkt als Linse. Beispielsweise kann die Schutzbeschichtung 11 als Wellenlängenkonversionsschicht ausgeführt sein.

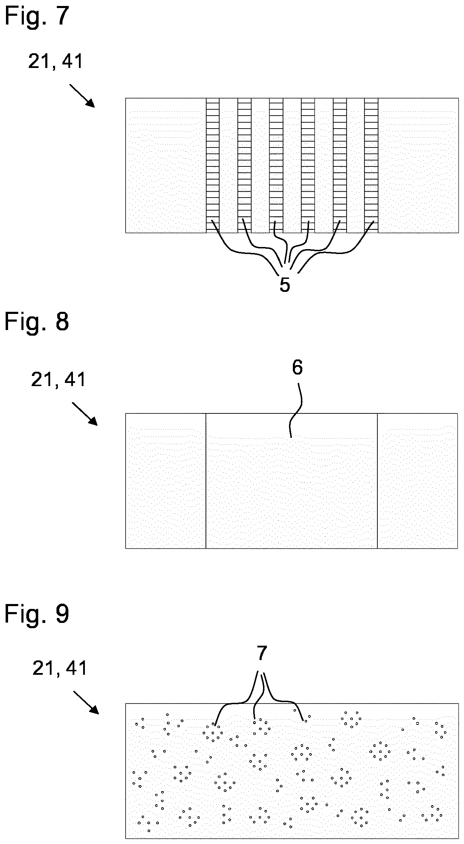

Der erste Trägerteil 21 und der zweite Trägerteil 22 weisen jeweils eine thermische Leitfähigkeit auf, wobei die thermische Leitfähigkeit des ersten Trägerteils 21 größer ist als die thermische Leitfähigkeit des zweiten Trägerteils 22. Insbesondere beträgt im gezeigten Ausführungsbeispiel thermische Leitfähigkeit des ersten Trägerteils 21 das 1,5-Fache der thermischen Leitfähigkeit des zweiten Trägerteils 22. Der erste Trägerteil 21 kann beispielsweise Vias, Dotierungen oder einen Metallblock aufweisen, wie im Folgenden im Zusammenhang mit den Figuren 7 bis 9 beispielhaft dargestellt und erläutert ist.

In Figur 2 ist eine schematische Schnittansicht einer Leuchtdiodenvorrichtung 1 gemäß einem weiteren Ausführungsbeispiel gezeigt. Im Unterschied zu dem in Figur 1 gezeigten Ausführungsbeispiel weist der erste Träger 2 eine Vielzahl von ersten Trägerteilen 21 auf, die jeweils lateral vom zweiten Trägerteil 22 umschlossen sind. Weiterhin weist die Leuchtdiodenvorrichtung 1 eine Vielzahl an Leuchtdiodenchips 3 auf, wobei jeweils ein Leuchtdiodenchip 3 auf einem ersten Trägerteil 21 aufliegt. Die ersten Trägerteile 21 erstrecken sich jeweils von einer ersten Oberfläche des ersten Trägers 2 zu einer der ersten Oberfläche gegenüberliegenden zweiten Oberfläche des ersten Trägers 2.

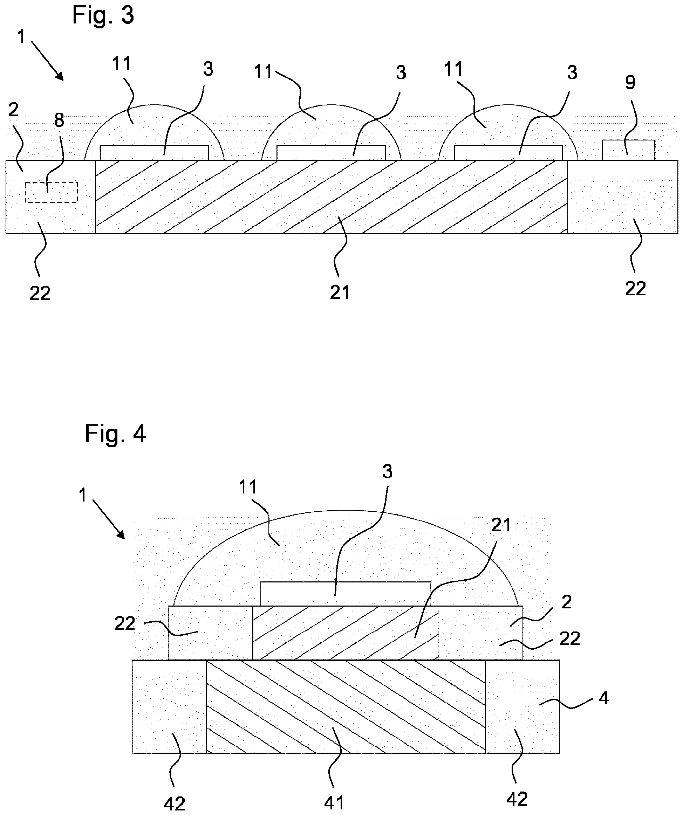

Figur 3 zeigt eine Leuchtdiodenvorrichtung 1 gemäß einem weiteren Ausführungsbeispiel. Im Unterschied zu dem in Figur 2 gezeigten Ausführungsbeispiel weist der erste Träger 2 nur einen ersten Trägerteil 21 auf, der lateral vom zweiten Trägerteil 22 umschlossen ist. Die Leuchtdiodenchips 3 sind alle auf dem ersten Trägerteil 21 angeordnet.

Des Weiteren weist die Leuchtdiodenvorrichtung 1 ein ESD-Schutzelement 8 auf, das als Varistor ausgeführt ist und durch einen Teilbereich des ersten Trägers 2, insbesondere durch einen Teilbereich des zweiten Trägerteils 22, gebildet ist. Weiterhin umfasst die Leuchtdiodenvorrichtung 1 ein Thermistorelement 9, das als NTC-Thermistorbauelement ausgeführt ist und als thermischer Sensor wirkt. Alternativ kann das Thermistorbauelement 9 auch als PTC-Thermistorbauelement ausgebildet sein.

In Figur 4 ist eine Leuchtdiodenvorrichtung 1 gemäß einem weiteren Ausführungsbeispiel gezeigt. Im Unterschied zu dem in Figur 1 gezeigten Ausführungsbeispiel weist die Leuchtdiodenvorrichtung 1 zusätzlich einen zweiten Träger 4 auf, wobei der erste Träger 2 auf dem zweiten Träger 4 angeordnet ist. Der zweite Träger 4 umfasst einen ersten Trägerteil 41 sowie einen zweiten Trägerteil 42, wobei der zweite Trägerteil 42 den ersten Trägerteil 41 lateral umgibt. Der erste Trägerteil 41 des zweiten Trägers 4 und der zweite Trägerteil 42 des zweiten Trägers 4 weisen jeweils eine thermische Leitfähigkeit auf, wobei der erste Trägerteil 41 des zweiten Trägers 4 eine höhere thermische Leitfähigkeit aufweist als der zweite Trägerteil 42 des zweiten Trägers 4.

Der erste Trägerteil 41 des zweiten Trägers 4 kann beispielsweise wie ein im Zusammenhang mit den Figuren 7 bis 9 beschriebener erster Trägerteil ausgeführt sein. Der erste Trägerteil 21 des ersten Trägers ist direkt auf dem ersten Trägerteil 41 des zweiten Trägers 4 angeordnet. Dadurch kann vorteilhafterweise besonders viel Wärme vom Leuchtdiodenchip 3 in Richtung des zweiten Trägers 4 abgeführt werden.

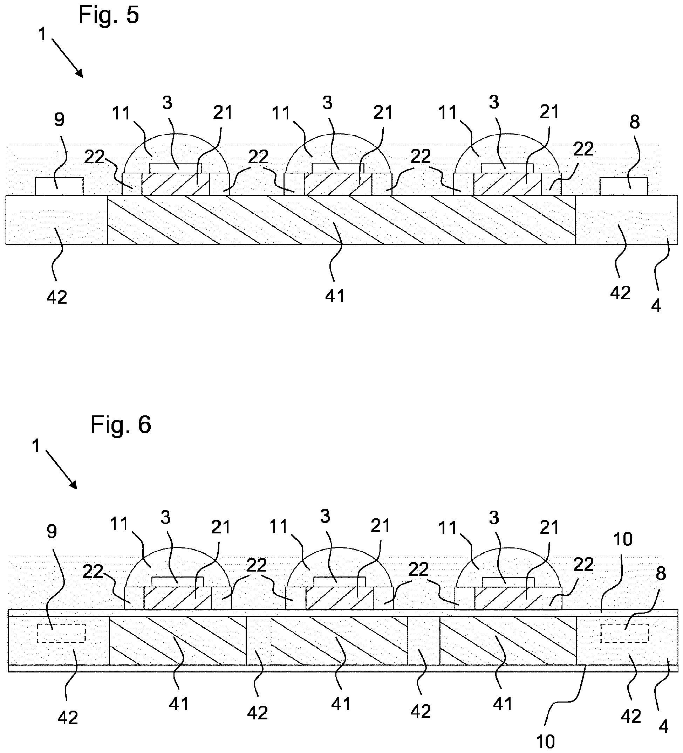

Figur 5 zeigt eine Leuchtdiodenvorrichtung 1 gemäß einem weiteren Ausführungsbeispiel. Im Unterschied zu dem in Figur 4 gezeigten Ausführungsbeispiel weist die Leuchtdiodenvorrichtung 1 eine Vielzahl von ersten Trägern 2 auf, wobei die ersten Träger 2 jeweils auf dem zweiten Träger 4, insbesondere auf dem ersten Trägerteil 41 des zweiten Trägers 4, angeordnet sind. Die ersten Träger 2 weisen jeweils einen ersten Trägerteil 21, einen zweiten Trägerteil 22 sowie einen auf dem ersten Trägerteil 21 angeordneten Leuchtdiodenchip 3 auf. Des Weiteren weist die Leuchtdiodenvorrichtung 1 ein ESD-Schutzbauelement 8 sowie ein Thermistorbauelement 9 auf, welche jeweils als diskrete Bauelemente ausgeführt sind und auf dem zweiten Träger 4 angeordnet sind. Alternativ kann die Leuchtdiodenvorrichtung 1 auch mehrere ESD-Schutzbauelemente 8 und Thermistorbauelemente 9 aufweisen, die jeweils auf den ersten Trägern 2 angeordnet sind.

In Figur 6 ist eine Leuchtdiodenvorrichtung 1 gemäß einem weiteren Ausführungsbeispiel gezeigt. Im Unterschied zu dem in Figur 5 gezeigten Ausführungsbeispiel weist der zweite Träger 4 eine Vielzahl von ersten Trägerteilen 41 auf, die jeweils lateral vom zweiten Trägerteil 42 des zweiten Trägers 4 umgeben sind. Dabei ist auf jedem ersten Trägerteil 41 des zweiten Trägers 4 jeweils ein erster Träger 2 angeordnet ist. Insbesondere ist jeder erste Trägerteil 21 des ersten Trägers 2 jeweils auf einem ersten Trägerteil 41 des zweiten Trägers 4 angeordnet. Dadurch kann eine besonders gute Wärmeableitung weg von den einzelnen Leuchtdiodenchips 1 erzielt werden.

Die Leuchtdiodenvorrichtung 1 weist weiterhin ein ESD-Schutzbauelement 8 und ein Thermistorbauelement 9 auf, die jeweils in den zweiten Trägerteil 42 des zweiten Trägers 4 eingebettet sind, wodurch sich vorteilhafterweise die Bauhöhe der Leuchtdiodenvorrichtung 1 verringern lässt. Der erste und der zweite Trägerteil 41, 42 des zweiten Trägers 4 weisen jeweils ein Metall auf. Der zweite Träger 4 weist weiterhin zwei elektrisch isolierende Schichten 10 auf, die auf zwei gegenüberliegenden Seiten des zweiten Trägers 4 angeordnet sind. Dabei wirkt die dem ersten Träger 2 zugewandte elektrisch isolierende Schicht 10 als elektrische Isolierung zwischen dem ersten und dem zweiten Träger 2, 4. Die dem ersten Träger 2 abgewandte Schicht 10 kann als elektrische Isolierung zwischen dem zweiten Träger 4 und einem dritten Träger (nicht gezeigt) dienen, auf dem der zweite Träger 4 angeordnet werden kann. Die elektrisch isolierende Schicht 10 weist Aluminiumoxid auf. Alternativ kann die elektrisch isolierende Schicht 10 auch zumindest eines der folgenden Materialien aufweisen: Aluminiumnitrid, Titanoxid, Siliziumoxid, Siliziumnitrid.

In Figur 7 ist eine schematische Darstellung eines ersten Trägerteils 21 des ersten Trägers 2 beziehungsweise eines ersten Trägerteils 41 des zweiten Trägers 4 gezeigt. Der erste Trägerteil 21, 41 umfasst eine Vielzahl von metallischen Vias 5, die im Wesentlichen parallel zueinander von einer ersten Seite des ersten Trägerteils 21, 41 zu einer gegenüberliegenden zweiten Seite des ersten Trägerteils 21, 41 verlaufen und die mit Silber gefüllt sind. Alternativ können die Vias 5 auch mit einem oder mehreren anderen Metallen, die vorzugsweise eine hohe thermische Leitfähigkeit aufweisen, gefüllt sein. Die Vias 5 sind beispielsweise von einer Keramik, einem Polymer oder einem Epoxidharz umgeben.

In Figur 8 ist eine schematische Darstellung eines ersten Trägerteils 21, 41 gemäß einem weiteren Ausführungsbeispiel gezeigt. Der erste Trägerteil 21, 41 umfasst einen Silber aufweisenden Metallblock 6, der lateral von Keramikmaterial umschlossen ist. Alternativ kann der Metallblock 6 auch aus Silber bestehen oder ein anderes Metall mit einer vorzugsweise hohen thermische Leitfähigkeit aufweisen oder daraus bestehen. Weiterhin ist es möglich, dass der Metallblock 6 von einem oder mehreren anderen Materialien, die sich vorzugsweise vom Material des Metallblocks 6 unterscheiden, wie zum Beispiel einem Polymer oder Epoxidharz, seitlich umschlossen ist.

Figur 9 zeigt einen ersten Trägerteil 21, 41 gemäß einem weiteren Ausführungsbeispiel. Der erste Trägerteil 21, 41 weist Dotierungen 7 auf. Die Dotierungen 7 sind als eine Vielzahl von Metallpartikeln, die in einem Keramikmaterial eingebettet sind, ausgeführt. Alternativ kann es sich bei den Dotierungen 7 auch um Metalldotierungen in einem Halbleitermaterial, wie zum Beispiel Si oder GaAs, handeln.

Mittels der in den Figuren 7, 8 und 9 gezeigten Ausführungsbeispiele für erste Trägerteile 21, 41 lässt sich die thermische Leitfähigkeit des ersten Trägerteils 21, 41 signifikant erhöhen. Dadurch kann vorteilhafterweise eine bessere Wärmeabfuhr weg vom Leuchtdiodenchip 1 erzielt werden.

Die in den gezeigten Ausführungsbeispielen beschriebenen Merkmale können gemäß weiteren Ausführungsbeispielen auch miteinander kombiniert sein, auch wenn solche Kombinationen nicht explizit in den Figuren gezeigt sind. Weiterhin können die gezeigten Leuchtdiodenvorrichtungen weitere oder alternative Merkmale gemäß den oben im allgemeinen Teil beschriebenen Ausführungsformen aufweisen.

Die Erfindung ist durch die Ansprüche definiert.

### Bezugszeichenliste

- 1: Leuchtdiodenvorrichtung
- 2: erster Träger
- 21: erster Trägerteil des ersten Trägers
- 22: zweiter Trägerteil des ersten Trägers
- 23: erste Oberfläche des ersten Trägers
- 24: zweite Oberfläche des ersten Trägers
- 3: Leuchtdiodenchip
- 4: zweiter Träger
- 41: erster Trägerteil des zweiten Trägers
- 42: zweiter Trägerteil des zweiten Trägers
- 5: Via
- 6: Metallblock
- 7: Dotierung
- 8: ESD-Schutzelement
- 9: Thermistorbauelement
- 10: elektrisch isolierende Schicht
- 11: Schutzbeschichtung

## Patentansprüche

1. Leuchtdiodenvorrichtung (1), aufweisend einen ersten Träger (2) und zumindest einen Leuchtdiodenchip (3), der auf dem ersten Träger (2) angeordnet ist, wobei
- der erste Träger (2) zumindest einen ersten und einen zweiten Trägerteil (21, 22) aufweist,
- der Leuchtdiodenchip (3) nur auf dem ersten Trägerteil (21) des ersten Trägers (2) aufliegt,
- der erste und der zweite Trägerteil (21, 22) jeweils eine thermische Leitfähigkeit aufweisen, und
- der erste Trägerteil (21) des ersten Trägers (2) vom zweiten Trägerteil (22) des ersten Trägers (2) lateral umschlossen ist,
**dadurch gekennzeichnet, dass**
die thermische Leitfähigkeit des ersten Trägerteils (21) mindestens das 1,5-fache der thermischen Leitfähigkeit des zweiten Trägerteils (22) beträgt, und
- der erste Trägerteil (21) des ersten Trägers (2) Dotierungen (7) aufweist, wobei die Dotierungen (7) als Metallpartikel, die in einem Keramikmaterial eingebettet sind, oder als metallische Dotierung in einem Halbleitermaterial ausgeführt sind.

2. Leuchtdiodenvorrichtung nach Anspruch 1, wobei die thermische Leitfähigkeit des ersten Trägerteils (21) mindestens das 5-fache der thermischen Leitfähigkeit des zweiten Trägerteils beträgt (22).

3. Leuchtdiodenvorrichtung nach einem der vorherigen Ansprüche, wobei
die Leuchtdiodenvorrichtung eine Mehrzahl von Leuchtdiodenchips (3) aufweist, die alle auf dem ersten Trägerteil (21) angeordnet sind.

4. Leuchtdiodenvorrichtung nach einem der vorherigen Ansprüche, aufweisend einen zweiten Träger (4), der zumindest einen ersten und einen zweiten Trägerteil (41, 42) aufweist, wobei
- der erste und der zweite Trägerteil (41, 42) des zweiten Trägers (4) jeweils eine thermische Leitfähigkeit aufweisen,
- die thermische Leitfähigkeit des ersten Trägerteils (41) des zweiten Trägers (4) mindestens das 1,5-fache der thermischen Leitfähigkeit des zweiten Trägerteils (42) des zweiten Trägers (4) beträgt,
- der erste Träger (2) auf dem zweiten Träger (4) angeordnet ist, und
- die ersten Trägerteile (21, 41) übereinander angeordnet sind.

5. Leuchtdiodenvorrichtung (1), aufweisend einen ersten Träger (2), auf dem zumindest ein Leuchtdiodenchip (3) angeordnet ist, und einen zweiten Träger (4), auf dem der erste Träger (2) angeordnet ist, wobei
- der erste und der zweite Träger (2, 4) jeweils zumindest einen ersten und einen zweiten Trägerteil (21, 41, 22, 42) aufweisen,
- der Leuchtdiodenchip (3) nur auf dem ersten Trägerteil (21) des ersten Trägers (2) aufliegt,
- die ersten und die zweiten Trägerteile (21, 41, 22, 42) jeweils eine thermische Leitfähigkeit aufweisen, und wobei
- der erste Trägerteil (21) des ersten Trägers (2) eine höhere thermische Leitfähigkeit aufweist als der zweite Trägerteil (22) des ersten Trägers (2),
- der erste Trägerteil (41) des zweiten Trägers (4) eine höhere thermische Leitfähigkeit aufweist als der zweite Trägerteil (42) des zweiten Trägers (4), und
- die ersten Trägerteile (21, 42) übereinander angeordnet sind,
- der erste Trägerteil (21) des ersten Trägers (2) vom zweiten Trägerteil (22) des ersten Trägers (2) lateral umschlossen ist, und
- der erste Trägerteil (41) des zweiten Trägers vom zweiten Trägerteil (42) des zweiten Trägers lateral umschlossen ist,
**dadurch gekennzeichnet, dass**
- der erste Trägerteil (21) des ersten Trägers (2) Dotierungen (7) aufweist, wobei die Dotierungen (7) als Metallpartikel, die in einem Keramikmaterial eingebettet sind, oder als metallische Dotierung in einem Halbleitermaterial ausgeführt sind.

6. Leuchtdiodenvorrichtung nach einem der vorhergehenden Ansprüche, wobei der erste Träger (2) eine erste Oberfläche, auf der der Leuchtdiodenchip (3) angeordnet ist, und eine zweite Oberfläche, die der ersten Oberfläche gegenüberliegt, aufweist, wobei sich der erste Trägerteil (21) des ersten Trägers (2) von der ersten zur zweiten Oberfläche (23, 24) erstreckt.

7. Leuchtdiodenvorrichtung nach einem der vorhergehenden Ansprüche, wobei der erste Trägerteil (21) des ersten Trägers (2) thermische Vias (5) aufweist, die sich von einer ersten Oberfläche des ersten Trägers, auf der der Leuchtdiodenchip (3) angeordnet ist, zu einer der ersten Oberfläche gegenüberliegenden zweiten Oberfläche des ersten Trägers (2) erstrecken.

8. Leuchtdiodenvorrichtung nach einem der vorhergehenden Ansprüche, wobei der erste Trägerteil (21) des ersten Trägers (2) einen Metallblock (6) aufweist.

9. Leuchtdiodenvorrichtung nach einem der vorhergehenden Ansprüche, wobei der erste und/oder zweite Träger (2, 4) ein ESD-Schutzelement (8) aufweist und das ESD-Schutzelement (8) als Varistor, als Silizium-Halbleiter-Schutzdiode oder als Polymer-ESD-Schutzelement ausgeführt ist.

10. Leuchtdiodenvorrichtung nach Anspruch 9, wobei das ESD-Schutzelement (8) durch einen Teilbereich des ersten oder zweiten Trägers (2, 4) gebildet wird.

11. Leuchtdiodenvorrichtung nach einem der vorhergehenden Ansprüche, wobei auf dem ersten Träger (2) ein NTC-Thermistorbauelement und/oder PTC-Thermistorbauelement angeordnet ist und das NTC- und/oder PTC-Thermistorbauelement mit dem Leuchtdiodenchip (3) verschaltet ist und einen thermischen Sensor zur Regulierung eines Steuerstroms des Leuchtdiodenchips (3) oder ein Überstromschutzelement bildet.

12. Leuchtdiodenvorrichtung nach einem der Ansprüche 4 bis 11, wobei der zweite Trägerteil (22) des ersten Trägers (2) und/oder der zweite Trägerteil (42) des zweiten Trägers (4) ein keramisches und/oder ein organisches Material aufweist.

13. Leuchtdiodenvorrichtung nach einem der Ansprüche 4 bis 11, wobei der zweite Trägerteil (22) des ersten Trägers (2) und/oder der zweite Trägerteil (42) des zweiten Trägers (4) ein metallisches Material aufweist, das mit einer elektrisch isolierenden Schicht (10) versehen ist.

14. Leuchtdiodenvorrichtung nach einem der Ansprüche 4 bis 13, aufweisend einen dritten Träger, wobei der zweite Träger (4) mit einer dem ersten Träger (2) abgewandten Seite auf dem dritten Träger angeordnet ist.

## Claims

1. Light-emitting diode device (1), having a first carrier (2) and at least one light-emitting diode chip (3), which is arranged on the first carrier (2), wherein
- the first carrier (2) has at least one first and one second carrier part (21, 22),
- the light-emitting diode chip (3) rests only on the first carrier part (21) of the first carrier (2),
- the first and second carrier parts (21, 22) each have a thermal conductivity, and
- the first carrier part (21) of the first carrier (2) is surrounded laterally by the second carrier part (22) of the first carrier (2),
**characterized in that**
the thermal conductivity of the first carrier part (21) is at least 1.5 times the thermal conductivity of the second carrier part (22), and
- the first carrier part (21) of the first carrier (2) has dopings (7), wherein the dopings (7) are embodied as metal particles embedded in a ceramic material or as metallic doping in a semiconductor material.

2. Light-emitting diode device according to Claim 1, wherein the thermal conductivity of the first carrier part (21) is at least five times the thermal conductivity of the second carrier part (22).

3. Light-emitting diode device according to either of the preceding claims, wherein the light-emitting diode device has a plurality of light-emitting diode chips (3), which are all arranged on the first carrier part (21).

4. Light-emitting diode device according to any of the preceding claims, having a second carrier (4), which has at least one first and one second carrier part (41, 42), wherein
- the first and second carrier parts (41, 42) of the second carrier (4) each have a thermal conductivity,
- the thermal conductivity of the first carrier part (41) of the second carrier (4) is at least 1.5 times the thermal conductivity of the second carrier part (42) of the second carrier (4),
- the first carrier (2) is arranged on the second carrier (4), and
- the first carrier parts (21, 41) are arranged one above the other.

5. Light-emitting diode device (1), having a first carrier (2), on which at least one light-emitting diode chip (3) is arranged, and a second carrier (4), on which the first carrier (2) is arranged, wherein
- the first and second carriers (2, 4) each have at least one first and one second carrier part (21, 41, 22, 42),
- the light-emitting diode chip (3) rests only on the first carrier part (21) of the first carrier (2),
- the first and second carrier parts (21, 41, 22, 42) each have a thermal conductivity, and wherein
- the first carrier part (21) of the first carrier (2) has a higher thermal conductivity than the second carrier part (22) of the first carrier (2),
- the first carrier part (41) of the second carrier (4) has a higher thermal conductivity than the second carrier part (42) of the second carrier (4), and
- the first carrier parts (21, 42) are arranged one above the other,
- the first carrier part (21) of the first carrier (2) is surrounded laterally by the second carrier part (22) of the first carrier (2), and
- the first carrier part (41) of the second carrier is surrounded laterally by the second carrier part (42) of the second carrier,
**characterized in that**
- the first carrier part (21) of the first carrier (2) has dopings (7), wherein the dopings (7) are embodied as metal particles embedded in a ceramic material or as metallic doping in a semiconductor material.

6. Light-emitting diode device according to any of the preceding claims, wherein the first carrier (2) has a first surface, on which the light-emitting diode chip (3) is arranged, and a second surface, which is opposite the first surface, wherein the first carrier part (21) of the first carrier (2) extends from the first to the second surface (23, 24).

7. Light-emitting diode device according to any of the preceding claims, wherein the first carrier part (21) of the first carrier (2) has thermal vias (5), which extend from a first surface of the first carrier, on which the light-emitting diode chip (3) is arranged, to a second surface of the first carrier (2) which is opposite the first surface.

8. Light-emitting diode device according to any of the preceding claims, wherein the first carrier part (21) of the first carrier (2) has a metal block (6).

9. Light-emitting diode device according to any of the preceding claims, wherein the first and/or second carrier(s) (2, 4) has/have an ESD protection element (8), and the ESD protection element (8) is in the form of a varistor, in the form of a silicon semiconductor protective diode or in the form of a polymer ESD protection element.

10. Light-emitting diode device according to Claim 9, wherein the ESD protection element (8) is formed by a subregion of the first or second carrier (2, 4).

11. Light-emitting diode device according to any of the preceding claims, wherein an NTC thermistor component and/or a PTC thermistor component are/is arranged on the first carrier (2) and the NTC and/or PTC thermistor component(s) is/are interconnected with the light-emitting diode chip (3) and form(s) a thermal sensor for regulating a control current of the light-emitting diode chip (3) or an overcurrent protection element.

12. Light-emitting diode device according to any of Claims 4 to 11, wherein the second carrier part (22) of the first carrier (2) and/or the second carrier part (42) of the second carrier (4) comprise(s) a ceramic and/or an organic material.

13. Light-emitting diode device according to any of Claims 4 to 11, wherein the second carrier part (22) of the first carrier (2) and/or the second carrier part (42) of the second carrier (4) comprise(s) a metallic material, which is provided with an electrically insulating layer (10).

14. Light-emitting diode device according to any of Claims 4 to 13, having a third carrier, wherein the second carrier (4) is arranged with a side facing away from the first carrier (2) on the third carrier.

## Revendications

1. Dispositif à diode électroluminescente (1), comprenant un premier support (2) et au moins une puce de diode électroluminescente (3) qui est disposée sur le premier support (2),
- le premier support (2) comportant au moins une première et une deuxième partie de support (21, 22),
- la puce de diode électroluminescente {3) n'étant en appui que sur la première partie de support (21) du premier support (2),
- la première et la deuxième partie de support (21, 22) présentant chacune une conductivité thermique, et
- la première partie de support (21) du premier support (2) étant entourée latéralement par la deuxième partie de support (22) du premier support (2), **caractérisé en ce que**
la conductivité thermique de la première partie de support (21) est égale à au moins 1,5 fois la conductivité thermique de la deuxième partie de support (22), et
- la première partie de support (21) du premier support (2) présente des dopages (7), les dopages (7) étant réalisés sous forme de particules métalliques noyées dans un matériau céramique ou sous forme de dopage métallique dans un matériau semi-conducteur.

2. Dispositif à diode électroluminescente selon la revendication 1, la conductivité thermique de la première partie de support (21) étant égale à au moins 5 fois la conductivité thermique de la deuxième partie de support {22}.

3. Dispositif à diode électroluminescente selon l'une des revendications précédentes, le dispositif à diode électroluminescente comportant une pluralité de puces de diode électroluminescente (3) qui sont toutes disposées sur la première partie de support (21).

4. Dispositif à diode électroluminescente selon l'une des revendications précédentes, comprenant un deuxième support (4) qui comporte au moins une première et une deuxième partie de support (41, 42),
- la première et la deuxième partie de support (41, 42} du deuxième support (4) présentant chacune une conductivité thermique,
- la conductivité thermique de la première partie de support (41) du deuxième support {4) étant égale à au moins 1,5 fois la conductivité thermique de la deuxième partie de support (42} du deuxième support (4),
- le premier support (2) étant disposé sur le deuxième support (4), et
- les premières parties de support (21, 41) étant disposées les unes au-dessus des autres.

5. Dispositif à diode électroluminescente {1), comprenant un premier support (2) sur lequel au moins une puce de diode électroluminescente (3) est disposée, et un deuxième support (4) sur lequel le premier support (2) est disposé,
- le premier et le deuxième support (2, 4) comportant chacun au moins une première et une deuxième partie de support (21, 41, 22, 42),
- la puce de diode électroluminescente (3) n'étant en appui que sur la première partie de support (21) du premier support (2),
- les première et deuxième parties de support (21, 41, 22, 42) présentant chacune une conductivité thermique, et
- la première partie de support (21) du premier support (2) présentant une conductivité thermique supérieure à celle de la deuxième partie de support (22) du premier support (2),
- la première partie de support (41) du deuxième support (4) présentant une conductivité thermique supérieure à celle de la deuxième partie de support (42) du deuxième support (4), et
- les premières parties de support (21, 42) étant disposées les unes au-dessus des autres,
- la première partie de support (21) du premier support (2) étant entourée latéralement par la deuxième partie de support (22) du premier support (2), et
- la première partie de support (41) du deuxième support étant entourée latéralement par la deuxième partie de support (42) du deuxième support,
**caractérisé en ce que**
- la première partie de support (21) du premier support (2) présente des dopages (7), les dopages {7) étant réalisés sous forme de particules métalliques noyées dans un matériau céramique, ou sous forme de dopage métallique dans un matériau semi-conducteur.

6. Dispositif à diode électroluminescente selon l'une des revendications précédentes, le premier support (2) comportant une première surface sur laquelle est disposée la puce de diode électroluminescente (3), et une deuxième surface qui est opposée à la première surface, la première partie de support (21) du premier support (2) s'étendant de la première à la deuxième surface (23, 24).

7. Dispositif à diode électroluminescente selon l'une des revendications précédentes, la première partie de support (21) du premier support (2) comportant des contacts traversants thermiques Vias (5) qui s'étendent d'une première surface du premier support sur laquelle est disposée la puce de diode électroluminescente (3) à une deuxième surface, opposée à la première surface, du premier support (2).

8. Dispositif à diode électroluminescente selon l'une des revendications précédentes, la première partie de support (21) du premier support (2) comportant un bloc métallique (6).

9. Dispositif à diode électroluminescente selon l'une des revendications précédentes, le premier et/ou deuxième support (2, 4) comportant un élément de protection ESD (8) et l'élément de protection ESD (8) étant réalisé sous la forme d'une varistance, d'une diode de protection à semi-conducteur silicium ou d'un élément de protection ESD en polymère.

10. Dispositif à diode électroluminescente selon la revendication 9, l'élément de protection ESD (8) étant formé par une partie du premier ou du deuxième support (2, 4).

11. Dispositif à diode électroluminescente selon l'une des revendications précédentes, un composant de thermistance NTC et/ou un composant de thermistance PTC étant disposé sur le premier support (2) et le composant de thermistance NTC et/ou PTC étant relié à la puce de diode électroluminescente (3) et formant un capteur thermique destiné à réguler un courant de commande de la puce de diode électroluminescente (3) ou un élément de protection contre les surintensités.

12. Dispositif à diode électroluminescente selon l'une des revendications 4 à 11, la deuxième partie de support (22) du premier support (2) et/ou la deuxième partie de support (42) du deuxième support (4) comportant un matériau céramique et/ou un matériau organique.

13. Dispositif à diode électroluminescente selon l'une des revendications 4 à 11, la deuxième partie de support {22} du premier support (2) et/ou la deuxième partie de support (42) du deuxième support (4) comportant un matériau métallique pourvu d'une couche électriquement isolante {10).

14. Dispositif à diode électroluminescente selon l'une des revendications 4 à 13, comportant un troisième support, le deuxième support (4) étant disposé avec un côté, opposé au premier support (2), sur le troisième support.
